# EUROPEAN PATENT SPECIFICATION

(11) **EP 1 267 212 B1**
(45) Date of publication and mention of the grant of the patent: **25.06.2008**
(21) Application number: 02254056.1
(22) Date of filing: 11.06.2002
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 13.06.2001 EP 01202274
(43) Date of publication of application: 18.12.2002
(60) Divisional application: 04020373.9
(73) Proprietor: ASML Netherlands B.V., 5504 DR Veldhoven (NL)
(72) Inventor: Kroon, Mark, 3531 VB Utrecht (NL); Van Der Werf, Jan Evert, 5581 JG Waalre (NL); Kok, Haico Victor, 5653 RD Eindhoven (NL)
(74) Representative: Leeming, John Gerard

(56) References cited:
- EP-A- 1 063 570
- US-A- 4 585 342
- US-A- 5 153 916
- US-A- 5 265 143
- US-A- 5 767 523

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means.
   Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.
   For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

An image sensing device, which may be mounted on the substrate table, is used to measure a mark pattern present in the patterning means so as to determine a plane of best focus of the lens, lens aberrations and to align the substrate table with respect to the patterning means. Presently, an image sensor comprises several separate sensors located behind detection structures that may take the form of gratings. Generally, one type of detection structure is present above a single sensor and several detection structures and respective sensors are required to determine the pattern characteristics as described. The detection structures may generally be processed in a single plate behind which the separate sensors are located. The use of separate sensors requires a rather large distance between neighboring sensors. This makes the imaging device comprising several complementary sensors and detection structures rather large, which is a problem when a narrow illumination field is being used, and which also limits measurements at the edge of the image field. Further, the present structured plate above the sensors is unflat due to a mechanical treatment to make the detection structures and to mount it above the separate sensors. This will cause capturing problems since not all detection structures will be in best focus simultaneously.

US 5,767,523 discloses an image sensing device for providing positioning, alignment and image quality information in which an illumination source projects an image of a reticle onto a detector comprising a plurality of different sensors formed on a single monolithic substrate; the detector is arranged such that openings in the detector match apertures in the reticle.

US 4,585,342 discloses an image sensing device comprising a plurality of unpatterned sub-detector regions onto which the image of a line of the reticle is scanned in order to determine the modulation transferfunction.

Especially when short-wavelength radiation, such extreme ultraviolet radiation in the range of 10 to 15 nm, is used the illumination field will become narrower and the requirements for the flatness of the plane in which the detection structures are present will become more stringent. Shorter wavelength radiation also requires the plate in which the detection structures are present to be thinner and the lime widths of the detection structures to be smaller. A very flat image sensing plate is also required for a level sensor that may be used to determine height and tilt of the substrate table.

It is an object of the present invention to provide an image-sensing device of which separate sensors and respective detection structures may be located very close so as to present limited dimensions.

It is a further object of the invention to provide an image-sensing device of which a front surface is very flat to have the various detection structures in one well-defined plane.

It is yet a further object to provide an image-sensing device of which dimensions are very insensitive to temperature variations.

These and other objects are achieved according to the invention in a lithographic projection apparatus according to claim 1.

According to a further aspect of the invention there is provided a device manufacturing method according to claim 7.

Although specific reference may be made to this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
Figure 1 schematically depicts a lithographic projection apparatus according to an embodiment of the invention;
Figure 2 schematically depicts a cross-section of an image sensing device being part of the apparatus of figure 1;
Figure 3 schematically depicts the image sensing device of figure 2 mounted on the substrate table shown in figure 1;
Figure 4 shows further details of a sensor being part of the image sensing device;
Figure 5A depicts an embodiment of neighboring image sensor markers above respective sensors in the image sensing device;
Figures 5B and 5C depict various marks for cooperation with the sensor marks of figure 5A;
Figure 6 depicts two further sets of image sensor marks and neighboring alignment marks;
Figure 7 depicts a region of the image sensor plate comprising several sets of image sensor marks and alignment marks;
Figure 8 depicts a top view of the substrate table holding a substrate and an image sensor plate;
Figure 9A depicts two image sensor plates according to the invention, which are processed from a 6-inch wafer; and
Figure 9B depicts one image sensor plate according to the invention, which is processed from one 4-inch wafer.

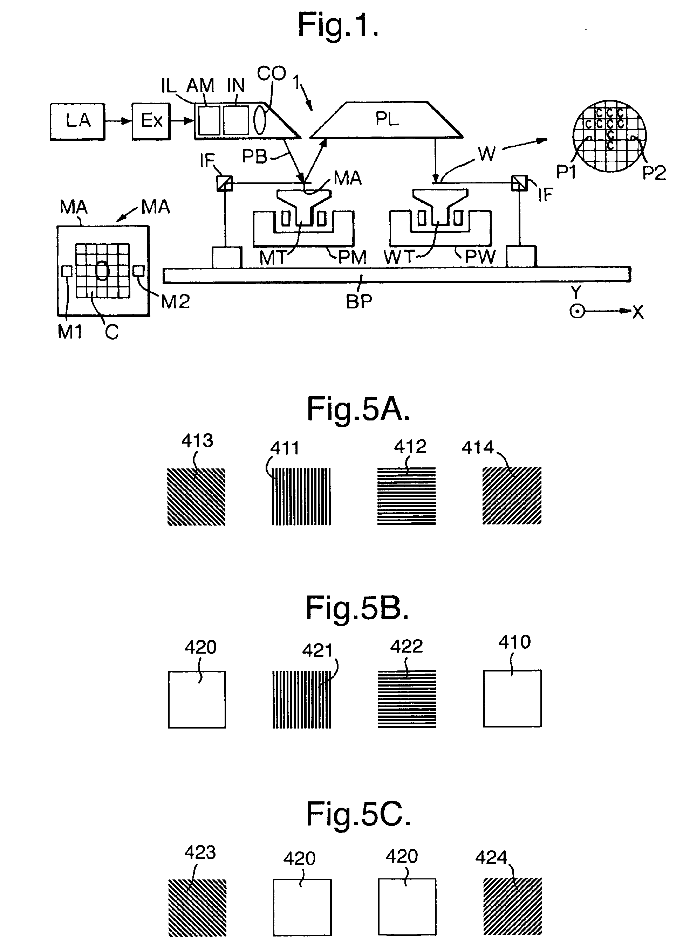

Figure 1 schematically depicts a lithographic projection apparatus according to a particular embodiment of the invention. The apparatus comprises:
A radiation system Ex, IL, for supplying a projection beam PB of radiation (*e.g.* UV or EUV radiation). In this particular case, the radiation system also comprises a radiation source LA;
A first object table (mask table) MT provided with a mask holder for holding a mask MA (*e.g.* a reticle), and connected to first positioning means for accurately positioning the mask with respect to item PL;
A second object table (substrate table) WT provided with a substrate holder for holding a substrate W (*e.g.* a resist-coated silicon wafer), and connected to second positioning means for accurately positioning the substrate with respect to item PL; and
A projection system ("lens") PL (*e.g.* reflective, a refractive or a catadioptric lens design) for imaging an irradiated portion of the mask MA onto a target portion C (*e.g.* comprising one or more dies) of the substrate W.

As here depicted, the apparatus is of a reflective type *(i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* an excimer laser, a laser-produced plasma source or a discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable direction mirrors); this latter scenario is often the case when the source LA is an excimer laser. The current invention and claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = ¼ or 1/5). In this manner, a relatively large target portion C can be exposed, without having to compromise on resolution.

A sensor plate 100 comprising an image sensing device (image sensor) 110 is mounted on substrate table WT, the image sensor being used for measuring the aerial image of a pattern on a mask that is provided on mask table MT. Such a measurement allows determining lens aberrations, lens magnification, and the focus plane of the lens, but also allows alignment of substrate table and mask pattern (mask table).

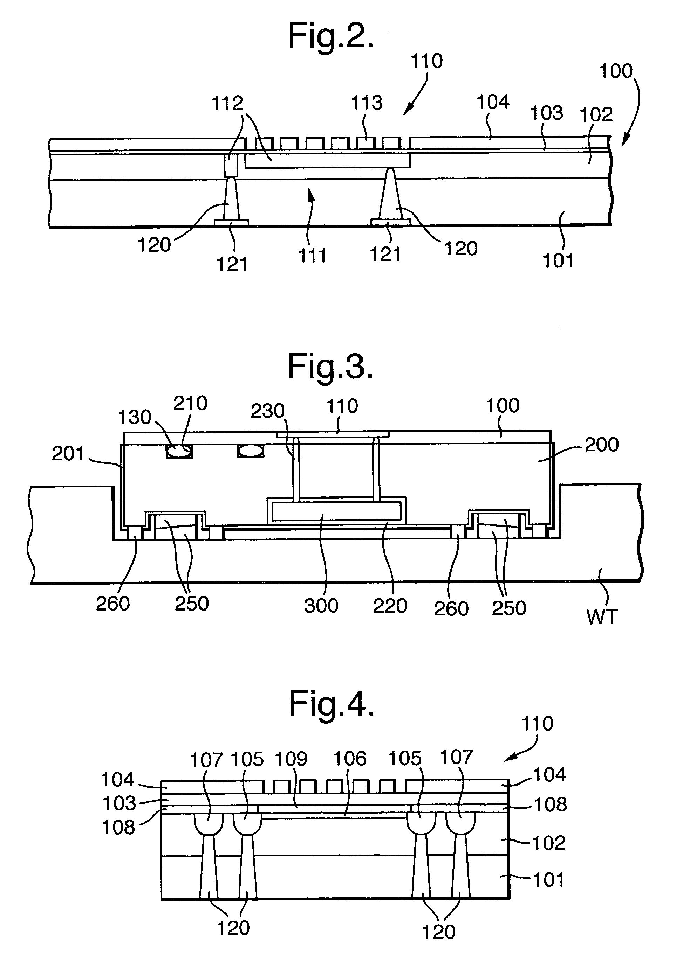

Figure 2 shows a view of the image sensor in cross-section. The image sensor is based on diode technology. Silicon photodiodes are semiconductor devices that are responsive to photons. Photons are absorbed and create electron-hole pairs to generate a flow of electrical current in an external electrical circuit, proportional to the incident power. Photodiodes can be used to detect the presence or variations in minute quantities of light and can be calibrated for extremely accurate measurements of intensities having a dynamic range of eleven orders of magnitude.

The image sensor of figure 2 is made in a silicon (or another semiconducting material such as germanium (Ge) or gallium arsenide (GaAs)) wafer 101 that has been polished on both sides to obtain a required flatness (ultra-flat) and thickness between 600 and 1000 µm. At one side of the wafer (denoted as the front side) a thin layer 102 of 1 to 10 µm silicon is epitaxially grown, in which layer the diodes 111 are processed at some locations in the wafer by means of known semiconductor manufacturing technology techniques including lithographic projection and ion implantation techniques. A diode is only schematically shown in figure 2. Electronic contacts 120 to the diodes are processed from the other side of the wafer (denoted as the back side). The contacts are established by etching holes in the back side, which pass through the wafer to the ion implanted regions 112 of the diode at the front side and the etched holes may be filled with tungsten, which is electrically conducting. The tungsten pillars are electrically connected to larger bond flaps 121 at the back side of the wafer, which are to be connected to processing electrons. In another embodiment the etched holes are left open at this stage. At some later stage they may be completely or partially (only on the walls, for instance) filled with a conductive glue when being mounted on an intermediate base plate, for instance.

The front surface of the wafer, in which the diodes were processed, is covered with a 10 to 20 nm thick layer 103 of silicon nitride (Si₃N₄) acting as a plasma etch stop and protective layer. Subsequently, a 50 to 100 nm thick metal layer 104 is sputtered on top of the silicon nitride layer. Marker patterns 113 are plasma-etched in the metal layer above the silicon diodes 111 using known lithographic projection techniques to define the marker patterns. The patterned metal layer above the photodiodes selectively passes EUV radiation the photodiode according to the pattern in the metal layer. Further, an additional zirconium (Zr) layer in the order of 100 nm may be provided over the diodes, for instance, directly below layer 103 in the embodiment shown. Such a zirconium layer would effectively block deep ultraviolet and visible radiation and pass in the order of 70% of the incident EUV radiation to the underlying diodes. Blocked radiation will thus not decrease the dynamic range and signal to noise ratio of the sensor or otherwise effect detection an aerial image of EUV radiation.

Sensor plate 100 comprises a major part of a silicon wafer in which several photodiodes covered by marker patterns are provided. Figure 3 shows that the image sensor plate 100 is carried by the upper surface of an intermediate base plate 200 to provide stability of the sensor plate and to also carry processing electronics 300 for the image sensor. Both upper and lower surfaces of the base plate are polished, the upper surface being polished to ultra-flat specifications. Image sensor and base plates are mounted together on substrate table WT. The base plate is preferably made from a low thermal expansion material like a glass ceramic material (being a glass with some additional ceramic to yield favourable properties) such as Zerodure™ (a material available from Schott glass, Hattenbergstrasse 10, 55120, Mainz, Germany) and ULE™ (a material available from Corning Incorporated, 1 River Front Plaza, Corning, NY 14831), or a glass such as quartz, presenting a coefficient of thermal expansion below 12x10⁻⁶K⁻¹. A sensor plate of those materials may also be contemplated.

A glue may be used to mount the image sensor plate 100 on the base plate 200 as shown in the left-hand part of figure 3. For this purpose grooves 210 are provided in the top surface for containing a glue 130 that pulls the sensor plate against the base plate after shrinkage. The sensor plate may also be attached to the base plate by direct bonding (being physical attraction between two (very flat) surfaces), which may provide a better overall flatness of the front side of the sensor plate 100. An embodiment adapted for direct bonding provides for a silicon dioxide layer (for instance, between 10 and 1000 nm thick) at the back side of the sensor plate for direct bonding to a quartz base plate since the physical properties of the silicon dioxide layer resemble those of the quartz base plate. General requirements for direct bonding are a good cleanliness and good flatness of the contacting surfaces. In case of direct bonding a very flat surface will be presented to the sensor plate for its support as is shown in the right-hand part of figure 3.

A cavity 220 is provided in the base plate for mounting an electronic circuitry plate 300 that comprises pre-amplifying electronics for the image sensor. The base plate may be 6 mm thick and the cavity may be 3 mm deep, for instance. Holes are drilled through the base plate to allow for electrical connections between sensor plate and electronic circuitry plate. The holes may be filled with some conductive glue (epoxy) that contacts respective bond flaps of sensor plate and electronic circuitry plate after assembling the whole unit. One may also provide rods 230 (gold rods or gold-plated steel rods, for instance) through the holes that are connected to their respective bond flaps using a conductive glue. The electronic circuitry plate 300 may be mounted in various manners in its cavity in the base plate, for instance, using a silicone gel. Generally, the sensor plate will be mounted first on the base plate, followed by providing electrical connections through the holes in the base plate and mounting the electronic circuitry plate. From the electronic circuitry plate further electric connections are provided to further processing electronics elsewhere in the system.

The base plate 200 is mounted in some removable manner on the substrate table WT, for instance, by a magnetic coupling by magnets 250, so that it can be removed for maintenance purposes. A substrate may be held on the substrate table by using a double-sided electrostatic chuck, which provides for attraction of a substrate to the chuck and of the chuck to the substrate table for holding of the substrate under vacuum conditions. The top side surface of sensor plate 100 is preferably in the same plane, or as close as possible, to the top side surface plane of the substrate. Chucks of various types and thickness may be employed for this purpose. Spacer plates 260 in between base plate and substrate table can be used to have the thickness of the sensor plate and base plate assembly adjusted accordingly. Such spacers are preferably provided around magnets 250 for holding the base plate on the substrate table and may also be attached to the base plate by direct bonding.

To shield the electronics inside cavity 220 and the electrical connections through base plate 200 from external electromagnetic influences, for instance, electromagnetic radiation present due to operation of an EUV plasma source, the base plate is preferably covered wholly or in part by a sufficiently thick metal layer 201. For most metals a layer thickness in the order of 1 µm is sufficient for blocking radio frequency electromagnetic radiation in the 1 Hz to 1 GHz regime. The metal layer may be provided by sputtering on the exterior surface of the base plate. Chromium is a preferred metal because of its high electrical conductivity, low oxidation and high sputtered layer quality. In case the sensor plate is attached to the base plate by direct bonding, it should be prevented that the metal layer is provided on that part of the base plate surface onto which the sensor plate is to be directly bonded at a later stage. To this end a dummy sensor plate is positioned on the base plate while providing metal layer 201. A silicon wafer having a silicon nitride (Si₃N₄) skin layer may be used for this purpose, since it ensures easy removal of the dummy plate and a uniform direct bonding. The dummy plate can be removed by moderate mechanical force or using an a-polar fluid. After attaching of sensor plate 100 to the non-covered area of base plate 200 an electrical connection between sensor plate and metal layer 201 is provided, for instance, by an electrical conductive glue around the perimeter of the sensor plate. Layer 201 is connected to, for instance, ground potential when the whole assembly is mounted on the substrate table WT. A clear area should also be provide for spacer plates in case such plates are to be attached to the base plate by direct bonding.

Figure 4 shows in more detail a cross-section of an example of a photo diode as processed in the wafer for detecting EUV radiation. A p-type epitaxially grown silicon layer 102 is grown on a p-type substrate (silicon wafer) 101. N-type regions 105 are provided at sides of a defect-free n-type region 106 in the epitaxial layer 102, as well as p-type regions 107. A field oxide 108 covers the n-type and p-type regions and electrical connects 120 are provided in contact with the n-type and p-type regions. A few nanometer thick platinum silicide or titanium silicide layer 109 is provided over the defect-free n-type region 106 on which radiation should be incident for detection purposes. The patterned area 113 in the metal layer 104 is provided above defect-free n-type region 106.

For aerial image sensing purposes several photo diodes are provided on the sensor plate 100, each having its own pattern provided in the metal layer on top. Figure 5A shows a series four neighboring image sensor mark patterns, each provided above its respective photo diode. Each pattern fills a square of 200 µm x 200 µm, for instance, and the patterns (and respective diodes) are approximately 200 µm apart, for instance. The series contains a -45° mark 413, an X direction mark 411, a Y direction mark 412 and +45° mark 414, respectively. The patterns are gratings having a certain pitch and line width and having their lines oriented as shown in the figure. The widths of the transmissive structures (referred to as groove widths or line widths in this specification) are in the order of 100 nm, for instance, between 30 and 300 nm, and the pitch may be in the order of 1 µm, for instance, between 0.3 and 9 µm.

Figures 5B and 5C show two series of mask mark patterns for cooperation with the series of sensor mark patterns of figure 5A. The series of figures 5B contains a ratio mark 420, an X direction mark 421, a Y direction mark 422 and a ratio mark 420, respectively, while the series of figure 5C contains a -45° mark 423, two ratio marks 420 and a +45° mark 424, respectively. The marks are again gratings, as above, except for the ratio marks, which are areas of constant reflection provided on the mask. They may be full reflective or 50% reflective, for instance. Each first mark of a series of mask marks is imaged onto the first mark of the series of sensor marks, each second mask mark onto the second sensor mark, etc. Outer dimensions of the mask marks are chosen such that an image of a mask mark will generally be large or smaller than its corresponding image sensor mark to allow for a relative scanning movement of mask and image sensor marks. However, dimensions of pitch and line width of an image of a mask mark will generally correspond to its respective image sensor mark (taking lens (de)magnification into account).

Marks shown have a constant pitch and line width across the mark. In general, pitch and line width may vary across a mark, for instance, presenting triplets of lines (also referred to as grooves in the context of this specification), the lines in a triplet having different line widths, for instance. Further, one may have equal line width across a mark and a varying pitch, for instance, for each triplet of lines (grooves) for additional functionality, or both have varying line width and varying pitch across the mark.

When scanning in the X and Y direction and imaging the series of mask marks of figure 5B onto the series of sensor marks of figure 5A yields aerial image information for the X direction and Y direction marks, while the -45° yield uniform intensity distributions to serve as ratio sensors together with their respective photo diodes. Signals detected by the ratio sensors are used for normalizing the signals yielded by the gratings and their respective photo diodes to correct for source fluctuations. The series of figure 5C yields aerial image information on the 45° directions.

Outer dimensions of the ratio mask marks 420 are shown to be identical to the outer dimensions of the grating mask marks (taking lens (de)magnification into account). However, the dimensions of one of the ratio mask marks may be chosen such that it will underfill its respective image sensor mark, while the dimensions of other ratio mask mark are chosen such it will overfill its respective image sensor mark for coarse capturing schemes while scanning. Scanning then yields the position of the small ratio mark spot within the capture range of its respective image sensor mark while the corresponding signal can be corrected for source fluctuations using the signal of the overfilled image sensor mark.

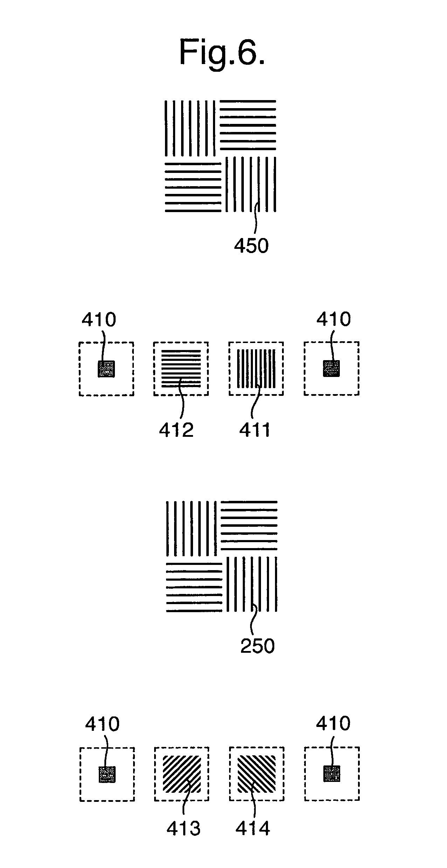

Figure 6 shows two alternative series of image sensor marks, the upper set comprising a ratio mark 410, an Y direction mark 412, and X direction mark 411 and another ratio mark 410, respectively, while the lower series comprises a ratio mark 410, a-45° mark 413, a +45° mark 414 and another ratio mark 410, respectively. The transmissive surface area of the square of ratio marks 410 equals the transmissive surface area of X and Y direction marks 411, 412 and of the -45° and +45° marks 413, 414. The series of mask marks to be used with these series of image sensor marks reflect the configuration of the series of image sensor marks. This embodiment presents two series of image sensor marks to yield X, Y, -45° and +45° information, while the previous embodiment only required one series. The considerations with regard to the dimensions of the marks are identical as set out above. Figure 6 shows further the outer dimensions of the photodiodes underlying the mark patterns in phantom.

However, it may be advantageous to have ratio marks taking the form of gratings over the photo diodes, which have groove widths (also being referred to as line widths in this specification) equal to the line widths of the neighboring image sensor mark patterns, to have the same spectral sensitivity for both ratio sensor and image sensor. It may even be further preferred to have those gratings in the same direction to also have an equal polarization dependency. Pitches may vary between image sensor and corresponding ratio sensor.

Returning again to figure 6, it also shows two alignment marks 450 and 250 to be used to align a substrate W present on the substrate table WT with respect to the substrate table. To this end alignment marks are provided on both the substrate WT and on the image sensor plate 100. An alignment module allows for aligning the alignment marks with regard to a reference using an alignment beam of radiation, while reading the corresponding positions of the substrate table using the interferometric measuring means IF. When the substrate table has been aligned with respect to the mask using the image sensor, the position of the substrate with respect to the mask is now also known. In the embodiment shown, the alignment marks are phase marks that are provided in the front side of the sensor plate employing lithographic projection and manufacturing techniques, such as etching. Such techniques allow processing of alignment and image sensor marks with a high accuracy with respect to each other, which is highly advantageous to be able to correctly position a substrate with respect to a pattern in a mask.

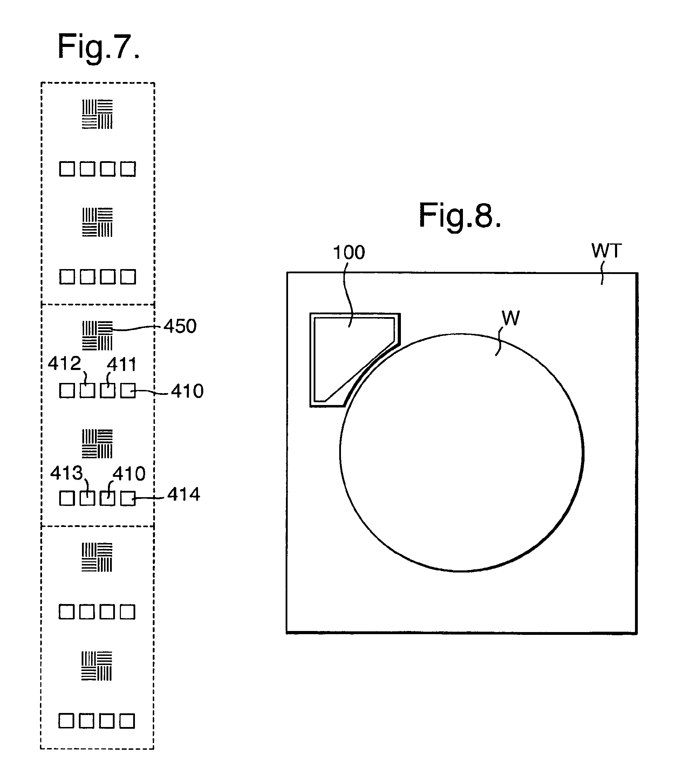

Multiple sets of image sensor marks, ratio marks, underlying photo diodes and alignment marks may be provided on the sensor plate. Each set of marks may be designed for specific purposes and/or measurements. Figure 7 depicts multiple sets corresponding to the ones of figure 6 present on the sensor plate.

Figure 8 shows a top view of substrate table WT on which a substrate W is located. Sensor plate 100 is located in a corner of the substrate table next to the substrate position. Optionally, another sensor plate may be located in another corner. Other kind of sensors may be located in the other corners.

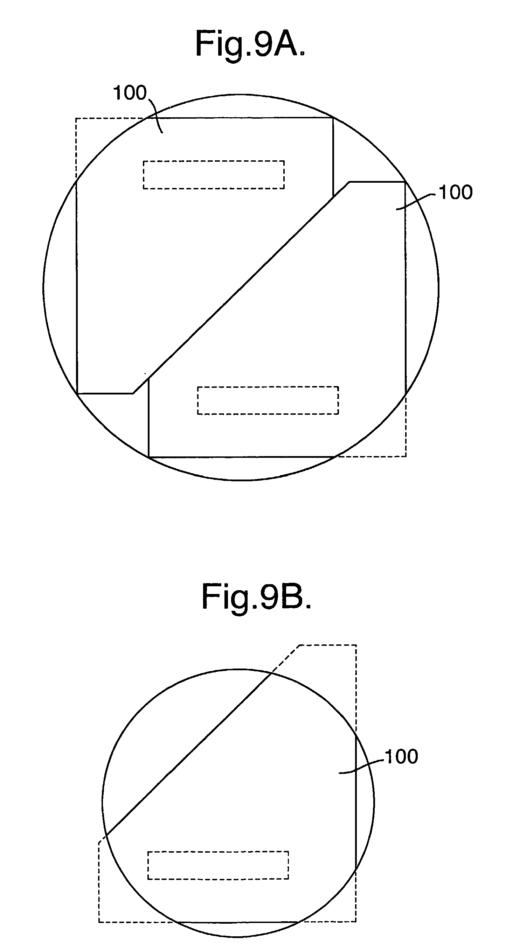

Figures 9A and 9B shows how sensor plates 100 may be cut from a 6-inch wafer and a 4-inch wafer, respectively. In the areas shows in phantom, the image sensors and marks as discussed above are processed using semiconductor manufacturing techniques. The reflective area may also be used by a level sensor (not shown) to determine height and tilt of the substrate table.

The image sensor and ratio sensor as described above may also be used for measuring the intensity of the projection beam and control of the dose of radiation incident on the substrate in the imaging process. However, the sensors will become polluted over time, predominantly by an (amorphous) carbon layer due to hydrocarbon molecules cracked under EUV radiation. Carbon shows a high absorption of EUV radiation; 1% of incident EUV radiation is absorbed in a 0.5 nm thick carbon layer. The presence of a carbon layer of unknown thickness prevents the use of the image (and/or ratio) sensor for calibrated EUV dose measurements. Visible light, or even infrared radiation, may be used to accurately measure the carbon layer thickness, to be able to correct for absorbed EUV radiation and to prevent cleaning of the sensors at short time intervals.

It is shown that radiation between 400 and 1100 nm may, to some extent, penetrate into grooves having a width in the order of 100 nm in case the radiation is polarized perpendicular to the grooves (TM polarization, as opposed to TE polarization). Such radiation will be the mark structures above the photo diodes, as described above, and will be detected by the photodiodes, which are sensitive to radiation above 400 nm.

It has further been shown that that radiation in the range of 400 to 1100 nm is readily absorbed by an (amorphous) carbon layer (absorption is even higher than for EUV radiation) and a carbon layer thickness can be accurately determined. Part of the beam of radiation in the range of 400-1100 nm can be split off using a beam splitter an be directed to a reference detector to correct for intensity fluctuations. EUV radiation would not be incident on such a reference sensor, and will therefore not cause carbon build-up on the reference sensor due to cracking of hydrocarbons by incident EUV radiation. The reference sensor will therefore remain clean. In case of a very stable light source, one might contemplate not employing a reference branch and not to employ TM polarized radiation.

Whilst specific embodiments of the invention have been described above, it will be appreciated that the invention may be practiced otherwise than as described. The description is not intended to limit the invention which is defined by the claims.

## Claims

1. A lithographic projection apparatus comprising:
a radiation system (Ex, IL) for providing a projection beam (PB) of radiation;
patterning means (MA);
a support structure (MT) supporting said patterning means (MA), the patterning means serving to pattern the projection beam according to a desired pattern so as to yield a patterned projection beam;
a substrate table (WT) for holding a substrate (W);
a projection system (PL) for projecting the patterned beam onto a target portion (C) of the substrate; and
an image sensing device (110) for measuring a pattern in the patterned projection beam;
wherein the image sensing device (110) comprises a slab (101) provided with at least two neighbouring radiation-sensitive sensors (112) on a first side of the slab, said sensors being an integral part of said slab and being sensitive to the radiation of the projection beam; and a film (104) of a material that is non-transparent to the radiation of the projection beam, the film being provided on the first side of the slab over said sensors (112) and being provided with patterned segments (113) above said sensors to selectively pass radiation of the projection beam to said sensors; said film of material and patterned segments being provided over both sensors, said patterned segments in said film comprising transmissive structures of at least substantially equal width across, said segments; wherein
one (413, 411, 412, 414) of the sensors is arranged to measure a patterned area in said cross-section of said patterned projection beam;
**characterized in that** the other one (413, 411, 412, 414) of said sensors is arranged to measure an intensity of a neighbouring unpatterned area of the cross-section of said patterned projection beam.

2. An apparatus according to claim 1, wherein said transmissive structures of said segments are at least substantially equally oriented.

3. An apparatus according to claim 1 or 2, wherein integrated transmissive surfaces areas of said segments are substantially in the same order of magnitude.

4. An apparatus according to claim 1, 2 or 3, wherein at least one of the segments comprises sets of grooves, each set having a separate pitch.

5. An apparatus according to claim 1, 2, 3 or 4, wherein a width of the transmissive structures of the segments is in the range of 30 to 300 nm.

6. An apparatus according to any one of the preceding claims, wherein the projection beam of radiation comprises extreme ultraviolet radiation having a wavelength from 5 to 20 nm.

7. A device manufacturing method comprising the steps of:
providing a substrate (W) that is at least partially covered by a layer of radiation-sensitive material;
providing a projection beam (PB) of radiation using a radiation system (Ex,IL);
using patterning means (MA) to endow the projection beam with a pattern in its cross-section;
projecting the patterned beam of radiation onto a target portion (C) of the layer of radiation-sensitive material; and
measuring a pattern in the patterned projection beam using an image sensing device (110) comprising a slab (101) provided with at least two neighbouring radiation-sensitive sensors (112) on a first side of the slab, said sensors being an integral part of said slab and being sensitive to the radiation of the projection beam; and a film (104) of a material that is non-transparent to the radiation of the projection beam, the film being provided on the first side of the slab over said sensors (112) and being provided with patterned segments above said sensors to selectively pass radiation of the projection beam to said sensors; said film of material and patterned segments being provided over both sensors, said patterned segments in said film comprising transmissive structures of at least substantially equal width across said segments; wherein
one (413, 411, 412, 414) of the sensors is arranged to measure a patterned area in said cross-section of said patterned projection beam;
**characterized in that** the other one (413, 411, 412, 414) of said sensors is arranged to measure an intensity of a neighbouring unpatterned area of the cross-section of said patterned projection beam.

## Patentansprüche

1. Lithographische Projektionsvorrichtung, mit:
• einem Strahlungssystem (Ex, IL) zum Bereitstellen eines Projektionsstrahls (PB) aus Strahlung;
• Musteraufbringungseinrichtungen (MA);
• einer Haltekonstruktion (MT), die die Musteraufbringungseinrichtungen (MA) hält, wobei die Musteraufbringungseinrichtungen dazu dienen, den Projektionsstrahl gemäß einem gewünschten Muster so zu mustern, dass ein gemusterter Projektionsstrahl erzielt wird;
• einem Substrattisch (WT) zum Halten eines Substrats (W);
• einem Projektionssystem (PL) zum Projizieren des gemusterten Strahls auf einen Zielbereich (C) des Substrats; und
• einem Bildmessfühler (110) zum Messen eines Musters im gemusterten Projektionsstrahl;
wobei der Bildmessfühler (110) eine Scheibe (101) umfasst, die wenigstens zwei benachbarte strahlungssensitive Sensoren (112) auf einer ersten Seite der Scheibe aufweist, wobei die Sensoren ein integraler Teil der Scheibe sind und auf die Strahlung des Projektionsstrahls empfindlich reagieren; und eine Schicht (104) aus einem Material, das für die Strahlung des Projektionsstrahls undurchlässig ist, wobei die Schicht auf der ersten Seite der Scheibe oberhalb der Sensoren (112) vorgesehen ist und oberhalb der Sensoren gemusterte Segmente (113) aufweist, um Strahlung des Projektionsstrahls selektiv zu den Sensoren hindurch zu lassen; wobei diese Schicht aus Material und gemusterten Segmenten oberhalb beider Sensoren angeordnet ist, wobei die gemusterten Segmente in der Schicht durchlässige Strukturen von zumindest im Wesentlichen gleicher Breite durch die Segmente umfassen; wobei einer der Sensoren so angeordnet ist, dass er einen gemusterten Bereich im Querschnitt des gemusterten Projektionsstrahls misst;
**dadurch gekennzeichnet, dass** der zweite (413, 411, 412, 414) der Sensoren so angeordnet ist, dass er eine Intensität eines benachbarten ungemusterten Bereichs des Querschnitts des gemusterten Projektionsstrahls misst.

2. Vorrichtung nach Anspruch 1, wobei die durchlässigen Strukturen der Segmente zumindest im Wesentlichen gleich ausgerichtet sind.

3. Vorrichtung nach Anspruch 1 oder 2, wobei integrierte durchlässige Oberflächenbereiche der Segmente im Wesentlichen die gleiche Größenordnung aufweisen.

4. Vorrichtung nach Anspruch 1, 2 oder 3, wobei wenigstens eines der Segmente Sätze von Rillen aufweist, wobei jeder Satz einen separaten Abstand aufweist.

5. Vorrichtung nach Anspruch 1, 2, 3 oder 4, wobei eine Breite der durchlässigen Strukturen der Segmente im Bereich von 30 bis 300 nm liegt.

6. Vorrichtung nach einem der vorhergehenden Ansprüche, wobei der Projektionsstrahl aus Strahlung extrem ultraviolette Strahlung mit einer Wellenlänge von 5 bis 20 nm umfasst.

7. Verfahren zum Herstellen eines Bauelements, das folgende Schritte umfasst:
• Bereitstellen eines Substrats (W), das zumindest teilweise von einer Schicht aus strahlungssensitivem Material bedeckt ist;
• Bereitstellen eines Projektionsstrahls (PB) aus Strahlung unter Verwendung eines Strahlungssystems (Ex,IL);
• Verwenden von Musteraufbringungseinrichtungen (MA), um dem Projektionsstrahl in seinem Querschnitt ein Muster aufzuprägen;
• Projizieren des gemusterten Strahls aus Strahlung auf einen Zielbereich (C) der Schicht aus strahlungssensitivem Material; und
• Messen eines Musters im gemusterten Projektionsstrahl unter Verwendung eines Bildmessfühlers (110), der eine Scheibe (101) umfasst, die wenigstens zwei benachbarte strahlungssensitive Sensoren (112) auf einer ersten Seite der Scheibe aufweist, wobei die Sensoren ein integraler Teil der Scheibe sind und auf die Strahlung des Projektionsstrahls empfindlich reagieren; und eine Schicht (104) aus einem Material, das für die Strahlung des Projektionsstrahls undurchlässig ist, wobei die Schicht auf der ersten Seite der Scheibe oberhalb der Sensoren (112) vorgesehen ist und oberhalb der Sensoren gemusterte Segmente aufweist, um Strahlung des Projektionsstrahls selektiv zu den Sensoren hindurch zu lassen; wobei diese Schicht aus Material und gemusterten Segmenten oberhalb beider Sensoren angeordnet ist, wobei die gemusterten Segmente in der Schicht durchlässige Strukturen von zumindest im Wesentlichen gleicher Breite durch die Segmente umfassen; wobei einer (413, 411, 412, 414) der Sensoren so angeordnet ist, dass er einen gemusterten Bereich im Querschnitt des gemusterten Projektionsstrahls misst;
**dadurch gekennzeichnet, dass** der zweite (413, 411, 412, 414) der Sensoren so angeordnet ist, dass er eine Intensität eines benachbarten ungemusterten Bereichs des Querschnitts des gemusterten Projektionsstrahls misst.

## Revendications

1. Appareil de projection lithographique comprenant :
un système de rayonnement (Ex, IL) pour délivrer un faisceau de projection (PB) de rayonnement ;
des moyens de mise en forme (MA) ;
une structure de support (MT) pour supporter lesdits moyens de mise en forme (MA), les moyens de mise en forme servant à mettre en forme le faisceau de projection conformément à un motif voulu de manière à produire un faisceau de projection mis en forme ;
une table de substrat (WT) pour maintenir un substrat (W) ;
un système de projection (PL) pour projeter le faisceau mis en forme sur une partie cible (C) du substrat ; et
un dispositif de détection d'image (110) pour mesurer un motif dans le faisceau de projection mis en forme ;
dans lequel le dispositif de détection d'image (110) comprend une plaque (101) munie d'au moins deux capteurs voisins sensibles au rayonnement (112) sur un premier côté de la plaque, lesdits capteurs étant une partie d'un seul tenant de ladite plaque et étant sensibles au rayonnement du faisceau de projection ; et un film (104) dans un matériau qui est non transparent au rayonnement du faisceau de projection, le film étant agencé sur le premier côté de la plaque au-dessus desdits capteurs (112) et étant muni de segments mis en forme (113) au-dessus desdits capteurs pour laisser passer de manière sélective un rayonnement du faisceau de projection jusqu'auxdits capteurs ; ledit film de matériau et lesdits segments mis en forme étant agencés au-dessus des deux capteurs, lesdits segments mis en forme dans ledit film comprenant des structures transmettrices ayant une largeur au moins sensiblement égale à travers lesdits segments ;
dans lequel l'un (413, 411, 412, 414) des capteurs est conçu pour mesurer une zone mise en forme dans ladite section transversale dudit faisceau de projection mis en forme ;
**caractérisé en ce que** l'autre (413, 411, 412, 414) desdits capteurs est conçu pour mesurer une intensité d'une zone voisine non mise en forme de la section transversale dudit faisceau de projection mis en forme.

2. Appareil selon la revendication 1, dans lequel lesdites structures transmettrices desdits segments sont orientées de manière au moins sensiblement égale.

3. Appareil selon la revendication 1 ou 2, dans lequel des aires de surfaces transmettrices intégrées desdits segments sont sensiblement du même ordre de grandeur.

4. Appareil selon la revendication 1, 2 ou 3, dans lequel au moins un des segments comprend des ensembles de rainures, chaque ensemble ayant un pas séparé.

5. Appareil selon la revendication 1, 2, 3 ou 4, dans lequel une largeur des structures transmettrices des segments est dans la plage de 30 à 300 nm.

6. Appareil selon l'une quelconque des revendications précédentes, dans lequel le faisceau de projection de rayonnement comprend un rayonnement ultraviolet extrême ayant une longueur d'onde de 5 à 20 nm.

7. Procédé de fabrication de dispositif comprenant les étapes de :
fournir un substrat (W) qui est au moins partiellement recouvert d'une couche de matériau sensible au rayonnement ;
fournir un faisceau de projection (PB) de rayonnement utilisant un système de rayonnement (Ex, IL) ;
utiliser des moyens de mise en forme (MA) pour doter le faisceau de projection d'un motif dans sa section transversale ;
projeter le faisceau de rayonnement mis en forme sur une partie cible (C) de la couche de matériau sensible au rayonnement ; et
mesurer un motif dans le faisceau de projection mis en forme en utilisant un dispositif de détection d'image (110) comprenant une plaque (101) munie d'au moins deux capteurs voisins sensibles au rayonnement (112) sur un premier côté de la plaque, lesdits capteurs étant une partie d'un seul tenant de ladite plaque et étant sensibles au rayonnement du faisceau de projection ; et un film (104) dans un matériau qui est non transparent au rayonnement du faisceau de projection, le film étant agencé sur le premier côté de la plaque au-dessus desdits capteurs (112) et étant muni de segments mis en forme au-dessus desdits capteurs pour laisser passer de manière sélective un rayonnement du faisceau de projection jusqu'auxdits capteurs ; ledit film de matériau et lesdits segments mis en forme étant agencés au-dessus des deux capteurs, lesdits segments mis en forme dans ledit film comprenant des structures transmettrices ayant une largeur au moins sensiblement égale à travers lesdits segments ; dans lequel l'un (413, 411, 412, 414) des capteurs est agencé pour mesurer une zone mise en forme dans ladite section transversale dudit faisceau de projection mis en forme ;
**caractérisé en ce que** l'autre (413, 411, 412, 414) desdits capteurs est agencé pour mesurer une intensité d'une zone voisine non mise en forme de la section transversale dudit faisceau de projection mis en forme.
